# EUROPEAN PATENT SPECIFICATION

(11) **EP 2 948 986 B1**
(45) Date of publication and mention of the grant of the patent: **08.05.2019**
(21) Application number: 13872283.0
(22) Date of filing: 11.07.2013
(51) Int. Cl.: H01L 31/042, H01L 31/052, H01L 31/0525, H02S 20/32, H02S 40/44, H02S 40/42, H02S 10/12, H01L 31/048, H02S 30/10, A01K 63/00

(54) **ENERGY PANEL, SYSTEM AND METHOD FOR HYBRID ENERGY PRODUCTION USING THE PANEL STRUCTURE**
ENERGIEPANEEL SOWIE SYSTEM UND VERFAHREN FÜR DIE HYBRIDENERGIEERZEUGUNG UNTER VERWENDUNG DER PANEELSTRUKTUR
PANNEAU DE PRODUCTION D'ÉNERGIE, AINSI QUE SYSTÈME ET PROCÉDÉ DE PRODUCTION D'ÉNERGIE HYBRIDE AU MOYEN DE LA STRUCTURE DE PANNEAU

(30) Priority: 22.01.2013 FR 1300138
(43) Date of publication of application: 02.12.2015
(73) Proprietor: RGR Partners Finland Oy, 01600 Vantaa (FI)
(72) Inventor: GABRIEL-ROBEZ, Roland, F-06000 Nice (FR)
(74) Representative: Berggren Oy, Helsinki & Oulu
(86) International application number: PCT/FI2013/050746
(87) International publication number: WO 2014/114845

(56) References cited:
- WO-A1-2012/045842
- WO-A2-2010/138086
- WO-A2-2012/104299
- JP-A- H1 062 017
- US-A- 5 733 382
- US-A1- 2008 302 357
- US-A1- 2008 302 357
- US-A1- 2010 314 509
- US-A1- 2010 314 509
- US-A1- 2012 006 496
- US-A1- 2012 037 210
- US-A1- 2012 060 898

## Description

### TECHNICAL FIELD OF THE INVENTION

The invention relates generally to energy panels for generating of energy, and more particular to energy panels comprising photovoltaic elements, energy panel arrangement comprising said energy panels, and method for energy production using the energy panel arrangement.

### BACKGROUND OF THE INVENTION

Solar radiation is the source of renewable energy that is used to produce electric power and heat, especially for local energy consumption. The intensity of the sunlight energy received on Earth's surface depends on, for example, climate conditions, and the latitude and the altitude of the Earth.

The photovoltaic element is currently used to convert solar energy into electric power. The generated electric power varies according to the illumination being exposed to the photovoltaic element. Typically, a plurality of interconnected photovoltaic elements is protected by a glass plate to form a photovoltaic panel. Because a single photovoltaic panel can produce only a limited amount of power, most installations contain multiple panels. A photovoltaic solar system typically includes an array of photovoltaic panels, an inverter, a battery and interconnecting wiring. In fixed orientation the panels are typically directed southward being inclined according to local latitude or optionally the photovoltaic system includes a solar tracker to orientate the panels toward the sun.

The increase in the temperature of the photovoltaic panel leads to a reduction in the photoelectric conversation efficiency of the photovoltaic elements. The heat exchanger can be used to cool the photovoltaic panel so as to reduce its operating temperature and to optimize its energy efficiency in the photoelectric conversion of solar radiation. The heat exchanger comprises structure for running air or thermal fluid that absorbs the heat which the photovoltaic panel produces as a result of exposure to solar radiation. The heat exchanger can also be used to produce thermal energy.

The assembly of the photovoltaic panel, heat exchanger and the fluid or air containing module is typically supported by a metal frame such as an aluminium frame to which each unit of the assembly is fixed with a simple seal joint. The through-holes for the tubular inlet and outlet structures of the heat exchanger as well as wiring for electric connections can be easily constructed through the supporting metal frame.

In the photovoltaic solar system or assembly where solar panels are supported by the metallic frames the solar panels are forced to form a rather rigid construction. Generally, a shape of such solar panels is flat, rectangular or square, and they are mostly fixed to pre-set position and rarely capable of orientating according to the sun position. Each of the solar panels that are assembled into the chassis of the metal frame occupies a large volume when installed, transported and stocked therefore increasing transport and stock costs. Last but not least is a rather monotone visual appearance of rigid solar panel structures.

Some examples of photovoltaic panels are presented in applications US 2012/0060898, WO 2010/138086, JP 10-62017, and WO 2012/045842.

### SUMMARY OF THE INVENTION

The object of the present invention is to overcome the above stated drawbacks. In addition the aim is to improve the known structure of the photovoltaic panel and propose economic variants for combining photovoltaic, thermal and aerodynamic technologies to optimize the thermal global yield of the ecological installations of renewable and clean energy recuperation.

Various aspects of embodiments of the invention are set out in the claims.

In a first aspect of the invention there is provided an energy panel according to the claim 1.

According to a second aspect of the invention there is provided an energy panel system comprising
- at least one energy panel according to any of claims 1-10, and
- a supporting structure configured to fasten the at least one energy panel to form an energy panel arrangement being oriented optimally to produce energy, wherein the supporting structure is configured to provide piping of the cooling means to the energy panels and electric conductors from the energy panels.

According to a third aspect of the invention there is provided a method for producing energy, comprising
- providing an energy panel system according to any of claims 11-17 comprising at least one energy panel according to any of claims 1-10,
- collecting electrical energy from the plurality of photovoltaic elements being exposed to solar radiation,
- feeding flowing material to the energy panel to cool down the plurality of photovoltaic elements,
- collecting thermal energy from the flowing material being exposed to thermodynamic heat transfer process during the cooling down, and
- supplying the collected energy or storing it.

### BRIEF DESCRIPTION OF THE DRAWINGS

For a more complete understanding of examples and embodiments of the present invention, reference is now made to the following descriptions taken in connection with the accompanying drawings in which:
Figure 1 depicts a perspective view of an example of a modified photovoltaic module underlying the invention;
Figures 2 depicts a cross-section view of an example of the modified photovoltaic module underlying the invention shown in Figure 1;
Figures 3 and 4 depict a cross-section view of embodiments of energy panels according to the invention;
Figures 5 and 6 depict a cross-section view of embodiments of energy panels according to the invention;
Figures 7-9 depict a cross-section view of embodiments of energy panel arrangements according to the invention;
Figure 10 depicts an example of an embodiment of energy panel arrangement according to the invention;
Figures 11 and 12 depict embodiments of energy panel system according to the invention;
Figure 13 depicts an embodiment of energy panel arrangement according to the invention;
Figure 14 depicts examples of embodiments of energy panel arrangement according to the invention shown from above;
Figure 15 depicts an embodiment of energy panel system according to the invention;
Figure 16 depicts an embodiment of energy panel system according to the invention;
Figure 17 depicts an embodiment of energy panel system according to the invention; and
Figure 18 depicts a flow diagram of an embodiment of method according to the invention.

### DETAILED DESCRIPTON OF THE DRAWINGS

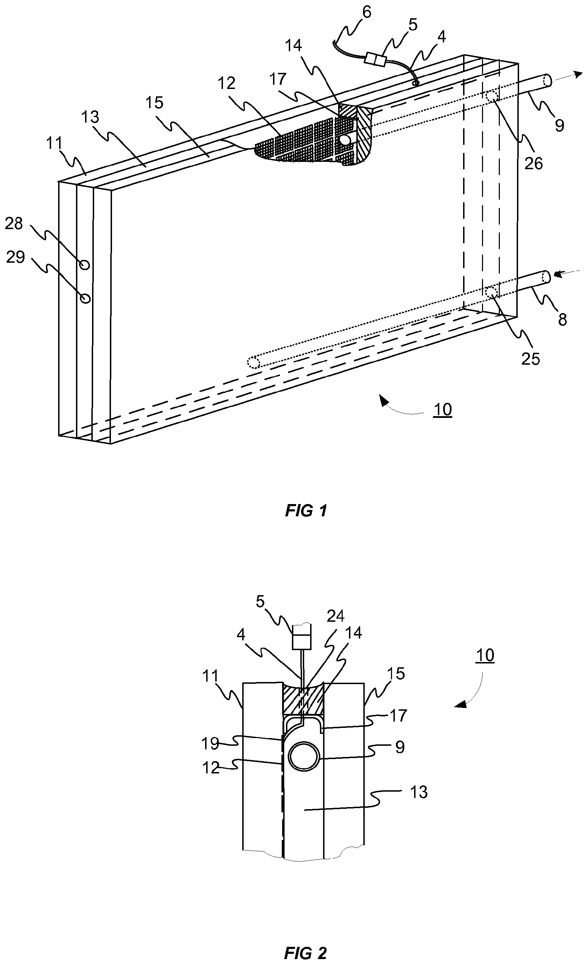

Examples and embodiments of the present invention and its potential advantages are understood by referring to figures 1 through 18 of the drawings.

Referring to figures 1 and 2 there is depicted a solar module 10 that comprises a photovoltaic panel 11 having a plurality of photovoltaic elements 12 covered by a glass plate and a back panel 15 where said panels 11, 15 are attached to each other with an attachment element 17, e.g. a strut, near the outer edge area of both panels. The attachment element 17 forms a supporting structure for the seal joint 14 that is fixed between the attachment element 17 and the outer edge of the panels, as shown in figure 2. The back plate 15 can be made of glass, metal, wood or synthetic material. The solar module 10 is called double glazing if the back panel 15 is made of glass, and triple glazing if the an extra glass panel is mounted between the photovoltaic panel and the back panel 17 made of glass. In the triple glazing solar module 10 the seal joint 14 is between each glass panel. The seal joint 14 is made of silicone, elastomer or polymer material. The space 13 between the photovoltaic panel 11 and the back panel 15 that is sealed with the seal joint 14 may contain air (as in a form of inertia gas or not) that serves as an insulating layer between the panels 11, 15. This technique enables to easily reduce the thermal exchange coefficient between the exterior and the interior. However, this technique does not allow exploitation of recuperating, controlling, regulating and optimizing the effective temperature of the installation.

According to an example underlying the invention, as shown in figures 1 and 2, the seal joint 14 that forms a frame structure around the solar module 10 to fasten the photovoltaic panel 11 and the back panel 15 tightly to each other is provided with at least one means to lead through 25 an inlet pipe 8 and at least one means to lead through 26 an outlet pipe 9 so that circulation of cooling agent can be arranged in the space 13 between the photovoltaic panel 11 and the back panel 15 that is sealed with the seal joint 14. The cooling agent can be, for example, liquid or gas that is temperature regulated or not, and it can in colour or not. The means to lead through 25 an inlet pipe 8 and the means to lead through 26 an outlet pipe 9 are disposed so that the circulation of the coolant agent is optimized. The seal joint 14 can be provided with means to lead through 24 electric wiring 4 from the photovoltaic elements 12 via electrical connection 19 that connects the plurality of interconnected photovoltaic elements 12 or part of the plurality of interconnected photovoltaic elements 12. The electric wiring 4 from the photovoltaic elements 12 can be led to an electric connector box 5 that provides connection to a further cabling 6. The seal joint 14 can also be provided with other means to lead through 28, 29 in order to connect to the space 13 or insert into the space 13 any other suitable objects, for example, a security valve for overpressure conditions, a manostat, a solenoid valve, a thermometer, a led lightning system, an outlet for drainage, or other possible components. The all means to lead through 24, 25, 26, 28, 29 are tightly sealed with the seal joint 14. Alternatively, the seal joint 14 forms a frame structure around the solar module 10 so that the photovoltaic panel 11 and the back panel 15 are tightly fastened to each other but the means to lead through 25 an inlet pipe 8 and the means to lead through 26 an outlet pipe 9 are drilled through the back panel and sealed with fluid-tight seals. In this case the seal joint 14 does not comprise the means to lead through 25 an inlet pipe 8 to the space 13 and the means to lead through 26 an outlet pipe 9 from the space 13.

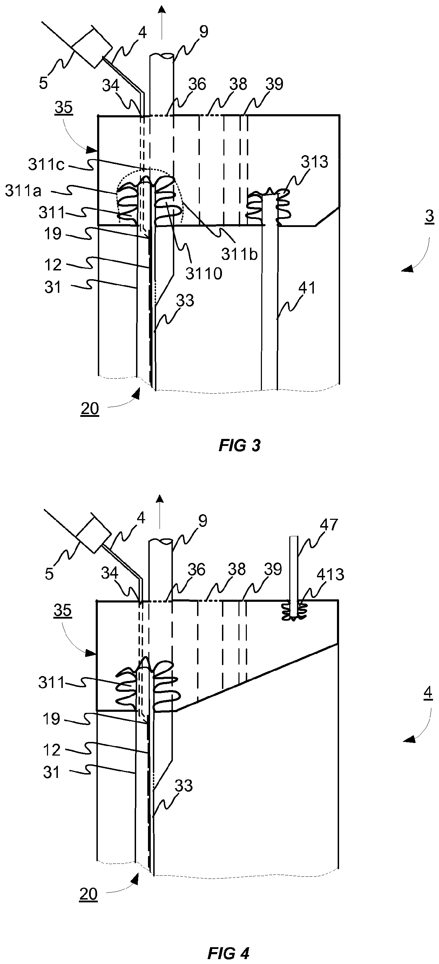

Referring to figure 3 there is depicted an energy panel 3 according to an embodiment of the invention that comprises a photovoltaic panel 31 having a plurality of photovoltaic elements 12 covered by a translucent plate and a cooling means 33 arranged to cool down the plurality of photovoltaic elements 12. The plurality of photovoltaic elements 12 can be mounted on a film. The translucent plate can be, for example, made of toughened glass. The photovoltaic panel 31 and the cooling means 33 together form a solar module 20. The cooling means 33 comprises, for example, a heat exchanger in a form of a thin panel that is made of stainless steel or corresponding material and the panel comprises channels for circulating fluid or gas in the cooling means 33. For example, PolarSol heat exchangers manufactured by Polarsol Oy in Joensuu, Finland, can be used.

The energy panel 3 according to an embodiment of the invention further comprises jointing means 35 that is configured to form a frame structure around the energy panel 3. The jointing means 35 is made of silicone, elastomer, polymer or other thermoplastics that is elastically deformable material having excellent sealing capability. The jointing means 35 is hermetic, liquid-tight and gas-tight. The jointing means 35 is provided with a holding groove 311 configured to fasten the photovoltaic panel 31 and the cooling means 33 against each other so that circulating fluid or gas in the cooling means 33 effectively cool down the plurality of the photovoltaic elements 12. The holding groove 311 tightly fastens the outer edge part of the solar module 20 for whole its length to the jointing means 35. As shown by dashed line in association with the holding groove 311 in figure 3, the holding groove 311 has two walls 311a, 311 b and bottom 311c to receive the outer edge part of the solar module 20 for whole its length around the solar module 20. The two walls 311a, 311b and the bottom 311 c are provided with elastic projecting lips 3110 that tightly grip the outer edge part of the solar module 20 when the outer edge of the solar module 20 is pushed towards the bottom 311c of the holding groove 311. At the same time the two walls 311a, 311b of the holding groove 311 with the projecting lips 3110 are pressing the photovoltaic panel 31 and the cooling means 33 panel of the solar module 20 against each other. Thus, the jointing means 35 with the holding groove 311 tightly fastens the photovoltaic panel 31 and the cooling means 33 against each so that photovoltaic elements 12 of the plurality of photovoltaic elements 12 are effectively cooled down. A pair of the projecting lips 3110 that is furthest from the bottom 311c of the holding groove 311 presses the edge part of the solar module 20 so tightly that fluid or gas cannot enter inside the holding groove 311. All inner pairs of the projecting lips 3110 still increase the tightness of the holding groove 311 in their part. The jointing means 35 with the holding groove 311 provides a tight and rigid frame structure for the solar module 20 and for the whole energy panel 3 as well.

According to an embodiment of the invention, the jointing means 35 of the energy panel 3 may further comprise another holding groove 313 that is configured to fasten an additional panel 41 to be part of the energy panel 3. The structure and properties of this other holding groove 313 is similar to the holding groove 311 as earlier described - off course the size and shape can vary according to the needs. The additional panel 41 can be, for example, a decorative or insulating panel made of wood, metal or synthetic material. The additional panel 41 can also be made of translucent, clear or colorful glass or synthetic material. The additional panel 41 may comprise, for example, an additional independent heat exchanger, electroluminescent display panel or one or more tangential lightning signs. The additional panel 41 may have an empty interior space where above-mentioned panel elements can be installed. The additional panel 41 may also be perforated. Optionally, another solar module 20 can be fastened with the other holding groove 313 to the energy panel 3. Also the solar module 10 depicted in figures 1 and 2 can be fastened to the holding groove 311 of the jointing means 35 or to the other holding groove 313 of the jointing means 35, or both. Therefore, the energy panel 3 may comprise any or both of the earlier described the solar modules 10, 20. The shape of the tangential outer surfaces of the energy panel 3 can be flat, planar or arcuate. Correspondingly the shape of the tangential surfaces of the solar modules 10, 20 and the additional panel 41 can be flat or arcuate.

According to an example of an embodiment of the invention, the jointing means 35 of the energy panel 3 comprises the first holding groove 311 that tightly fastens the outer edge part of the photovoltaic panel 31 and the second holding groove 313 that tightly fastens the outer edge part of the additional panel 41. There is formed between the photovoltaic panel 31 and the additional panel 41 a space that is surrounded by the fluid- and gas-tight jointing means 35. By providing the jointing means 35 with at least one means to lead through an inlet pipe 8 to the space and at least one means to lead through 36 the outlet pipe 9 from the space, the circulation of fluid or gas can be arranged in the space. This circulation can be used, for example, to cool down the plurality of the photovoltaic elements 12 of the photovoltaic panel 31. This circulation can also be used to provide informatics or decorative effects, for example, by changing the color of the fluid or gas.

Referring to figure 4 there is depicted an energy panel 4 according to an embodiment of the invention in which the jointing means 35 in addition to the holding groove 311 further comprises another holding means 413 configured to fasten the energy panel 4 to appropriate supporting structure 47, for example, a support panel or wall or other fixed and rigid structure to which the energy panel 4 is meant to be finally installed. The structure and properties of this holding groove 413 is similar to the holding groove 311 as earlier described - the size and shape varying according to the needs. The support structure 47 can be also part of an assembly of two or more energy panels 4 where it connects different energy panels 4 to each other. The jointing means 35 of the energy panel 3 of figure 3 may also comprise still another holding means 413 of figure 4 configured to fasten the energy panel 4 to the supporting structure 47 in addition to the holding groove 311 to fasten the solar module 10, 20 and the holding groove 313 to fasten the additional panel 41. The shape of the tangential outer surfaces of the energy panel 4 can be flat or arcuate. Correspondingly the shape of the tangential surfaces of the solar modules 10, 20, the additional panel 41 and the support structure 47 can be flat, planar or arcuate.

According to an embodiment of the invention, as depicted in figures 3 and 4, the jointing means 35 of the energy panel 3, 4 may further comprise at least one means to lead through an inlet pipe (not shown) to the cooling means 33 and at least one means to lead through 36 the outlet pipe 9 from the cooling means 33 so that circulation of cooling agent can be arranged in the channels of the cooling means 33. The cooling means 33 is, for example, a heat exchanger in a form of a thin panel that is pressed towards the photovoltaic panel 31. The thin panel 33 comprises channels for circulating fluid or gas in the cooling means 33. The jointing means 35 is further provided with means to lead through 34 electric wiring 4 from the plurality of the photovoltaic elements 12 via electrical connection 19 that connects the plurality of interconnected photovoltaic elements 12 or part of the plurality of interconnected photovoltaic elements 12. The electric wiring 4 is connected to the electric connector 5 for supplying the electric power further. The jointing means 35 can also be provided with other means to lead through 38, 39 in order to connect or insert to the space between solar module 20 and the additional panel 41 any other suitable objects., for example, a security valve, a manostat, a solenoid valve, a thermometer, a led lightning system, an outlet for drainage, or other such possible components. All the means to lead through 34, 36, 38, 39 are tightly sealed after connecting or inserting the object to the space between solar module 20 and the additional panel 41. In an example, fluid or gas is lead through one of the means to lead through 38, 39 to the space between solar module 20 and the additional panel 41 that is surrounded by the jointing means 35. The fluid or gas can be maintained inside the space, or it can be circulated to another one of the means to lead through 38, 39 to exit the fluid or gas from the space.

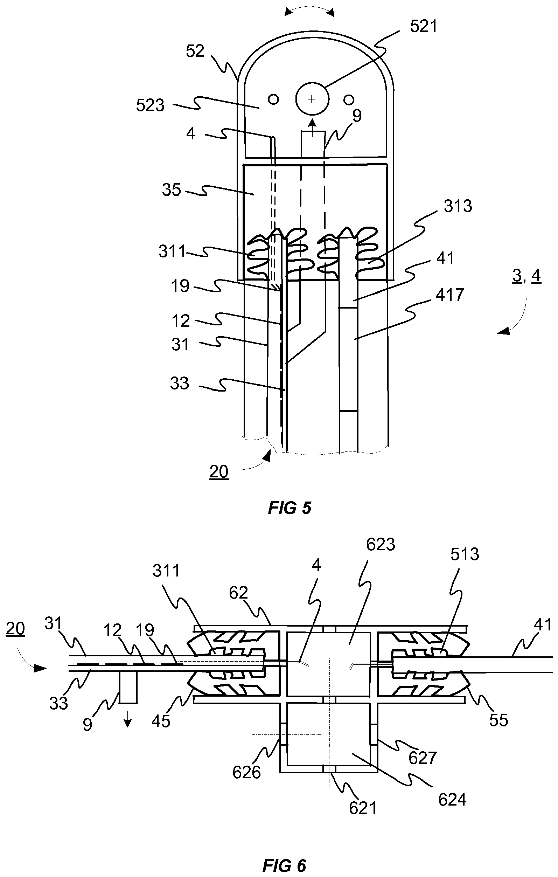

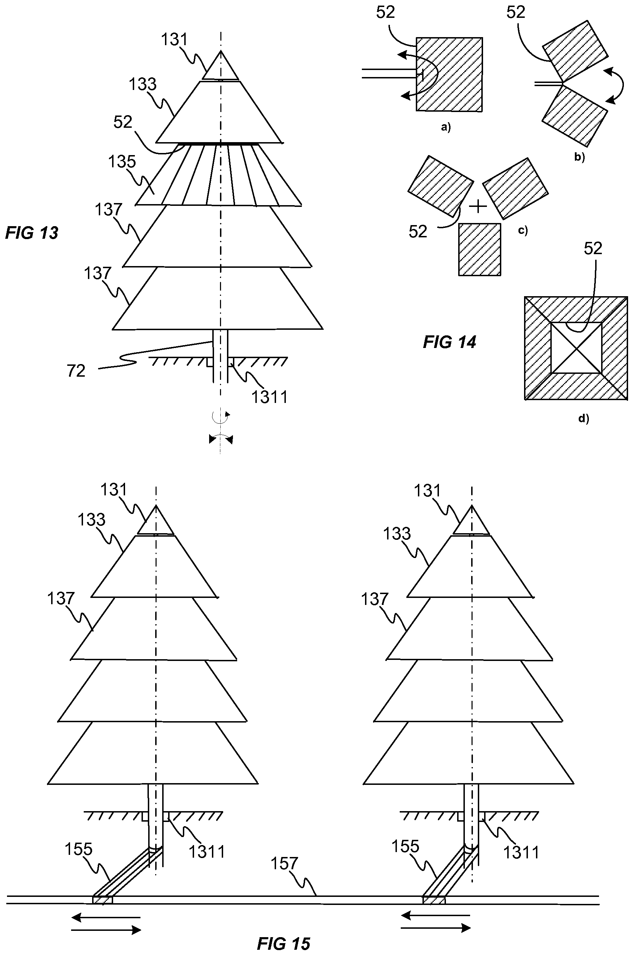

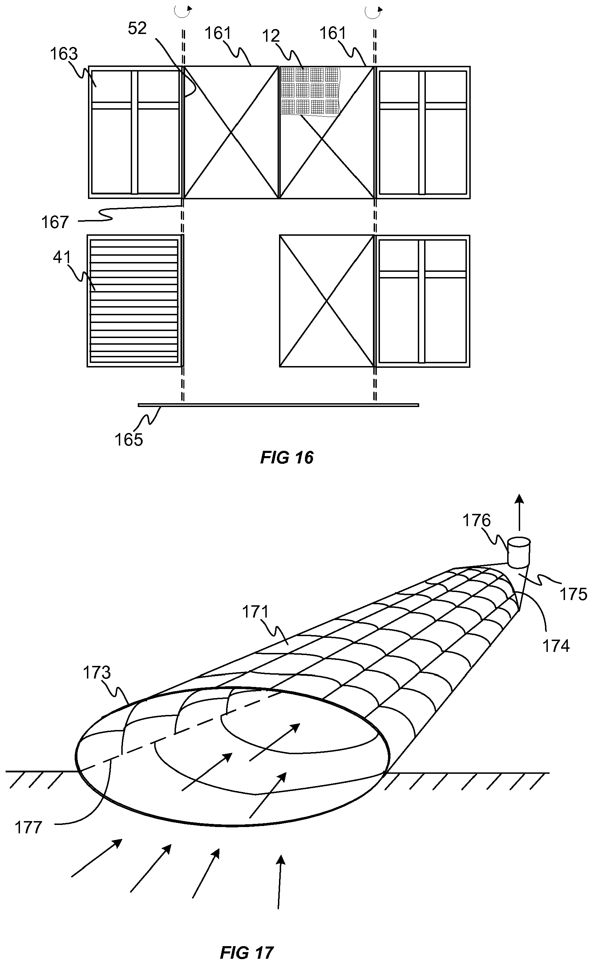

Figure 5 depicts an energy panel 3, 4 according to an embodiment of the invention in which the jointing means 35 is connected to a supporting structure. The supporting structure comprises a profiled frame portion 52 that includes a compartment suitable for receiving the jointing means 35 and tightly fastening the jointing means 35 to the profiled frame portion 52 so that the energy panel 4, 5 is also tightly fastened to the profiled frame portion 52 at least at one of its sides. The profiled frame portion 52 includes also another compartment 523 that is configured to be suitable for receiving the inlet pipe 8 and the outlet pipe 9 of the cooling means 33, and electric wiring 4 and other component connections from the appropriate means to lead through 34, 36, 38, 39 of the jointing means 35. This compartment 523 forms a chute for piping, cabling and other connections to and from the energy panel 35. The profiled frame portion 52 can be connected to a shaft 521 that is arranged in one of its compartments so that the profiled frame portion 52 and the energy panel 35 fastened to the profiled frame portion 52 can be designed to be rotatable around a rotation axis of the shaft 521. The rotation shaft 521 can be installed e.g. in the same compartment 523 where the pipe and cable chute for the piping 8, 9 for the cooling means and wiring 4 is arranged. Actually, the hollow shaft 521 can serve as a chute for cables, pipes, tubes and other component connections to pass. This rotatable profiled frame portion 52 can be used to orientate the energy panel 35 toward the sun direction for optimal energy production. In an example, the supporting structure comprises several profiled frame portions 52 each of them fastening one energy panel 3, 4 and the shaft 521 to which the several profiled frame portions 52 are rotatably connected. Alternatively, the supporting structure comprises single profiled frame portion 52 that fastens several energy panels 3, 4 and the shaft 521 to which the profiled frame portion 52 is rotatably connected. The shaft 521 can be rotated e.g. by the motor, and the orientation of the energy panels 3, 4 can be controlled. This kind of supporting structures and orientation control of the energy panels 3, 4 can be used, for example, in energy panel arrangements that are discussed more detail in association with figures 13-15 (energy tree and energy forest) and figure 16 (shuttered buildings). This compartment 523 or the shaft 521 can serve as a chute for cables, pipes, tubes and other component connections to pass from one energy panel to another.

Figure 6 depicts an energy panel arrangement according to an embodiment of the invention in which a pair of jointing means 45, 55 is connected to a supporting structure. The supporting structure comprises a profiled frame portion 62 that includes a first compartment suitable for receiving the jointing means 45 and tightly fastening the jointing means 45 to the profiled frame portion 62 so that the energy panel 20 is also tightly fastened to the profiled frame portion 62 at least at one of its sides. The profiled frame portion 62 further includes a second compartment suitable for receiving another jointing means 55 (comprising second holding groove 513 to fasten the panel) and tightly fastening the jointing means 55 to the profiled frame portion 62 so that another energy panel 20 or additional panel 41 or both is also tightly fastened to the profiled frame portion 62 at least at one of its sides. The profiled frame portion 62 includes also one or two compartments 623, 624 that is/are configured to be suitable for receiving the inlet pipe 8 and the outlet pipe 9 of the cooling means 33, and electric wiring 4 and other connection from the appropriate means to lead through 34, 36, 38, 39 of the jointing means 35. This compartment 623, 624 forms a chute for piping, cabling and other connections to and from the energy panel, and between two or more energy panels. For example, through-holes 626 and 627 can be used to lead the connections to and from the chute compartment 624 to energy panels. The profiled frame portion 62 may further comprise fixing means 621 to fix the energy panel arrangement to its position.

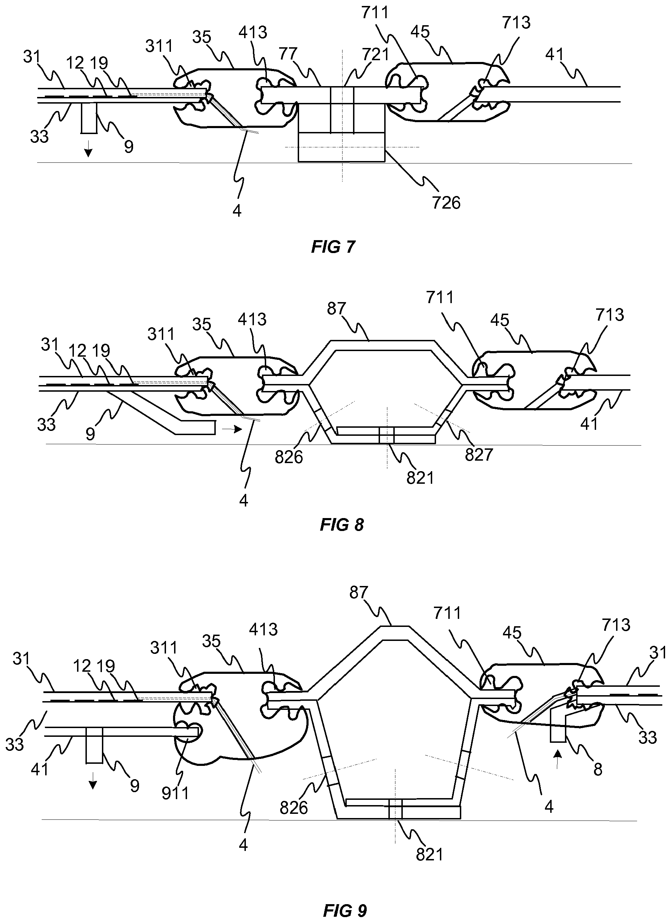

Figure 7 depicts an energy panel arrangement according to an embodiment of the invention in which a pair of jointing means 35, 45 is connected to a supporting structure 77. The first joint means 35 comprises a second holding groove 413 configured to receive an edge of the supporting structure 77 and tightly fasten the supporting structure 77 to the first jointing means 35. Correspondingly, the second joint means 45 comprises a first holding groove 711 configured to receive an edge of the supporting structure 77 and tightly fasten the supporting structure 77 to the second jointing means 45. The first joint means 35 also comprises a first holding groove 311 configured to tightly fasten the solar module 10, 20 or additional panel 41 to the first jointing means 35, and the second joint means 45 also comprises a second holding groove 713 configured to tightly fasten the solar module 10, 20 or additional panel 41 to the first jointing means 35. The jointing means 35, 45 comprises means to lead through 34 wiring 4 and other connections from the solar module 10, 20. The supporting structure 77 comprises means to lead through 726 piping, cabling and other connections between adjacent energy panels. The supporting structure 77 may comprise fixing means 721, for example bolts or screws, to fix the energy panel arrangement to its desired position. The supporting structure 77 can, for example, be made of wood, metal or synthetic material and different layouts are possible.

Figure 8 depicts an energy panel arrangement according to an embodiment of the invention in which a pair of jointing means 35, 45 is connected to a supporting structure 87. Compared to the energy panel arrangement shown in the previous figure 7, the supporting structure 87 differs in that it comprises several parts which facilitate assembly and fixing the arrangement to its position. In an example, the supporting structure 87 is composed of three different profiled parts. Two of the profiled parts comprise means for lead through 826, 827 piping, cabling and other connections to and from adjacent energy panels, and fixing means 821 to fix the energy panel arrangement to its position. One of the profiled parts form a cover part or a lid to the supporting structure 87 that obscures the chute for piping, cabling and other connections between energy panels of the energy panel arrangement that is formed inside the supporting structure 87. The cover or lid may also contain a safety valve, discharge spout or other similar security component. The supporting structure 87 is preferably made of profiled metal.

Figure 9 depicts an example of an energy panel arrangement according to an embodiment of the invention in which a pair of jointing means 35, 45 is connected to the supporting structure 87 that has been already discussed in the previous paragraph. Compared to the energy panel arrangement shown in the previous figure 8, the first joint means 35 comprises, in addition to the second holding groove 413, a first holding groove 311 configured to tightly fasten the photovoltaic panel 31 to the first jointing means 35 and a third holding groove 911 configured to tightly fasten the additional panel 41 to the first jointing means 35. There is formed an interior space 33 between the photovoltaic panel 31 and the additional panel 41 that can be filled e.g. with fluid or gas, if the panels 31, 41 are made of fluid- and gas-tight material. To provide circulation of fluid or gas to the interior space the inlet pipe 8 and outlet pipe 9 are arranged to the additional panel 41, for example. Preferably, circulation of heat transfer fluid is provided to the interior space for cooling down the plurality of the photovoltaic elements 12. As an example, the second holding groove 713 of the second joint means 45 is configured to tightly fasten solar module 20 to the second jointing means 45. The second jointing means 45 also comprises means to lead through the inlet pipe 8 to the cooling means 33 and means to lead through the wiring 4 from the photovoltaic panel 31.

The supporting structure 52, 62, 77, 87 is configured to fasten one or several energy panels 3, 4 to form an energy panel arrangement and to orientate the energy panel arrangement optimally to produce energy from solar radiation. The supporting structure 52, 62, 77, 87 comprises fixing means 521, 621, 721, 821 to fix the energy panel arrangement to a permanent or movable position so that the plurality of photovoltaic elements 12 receive optimally solar radiation. The energy panel arrangement can be fixed e.g. on roofs, walls, ground, masts, towers or other locations.

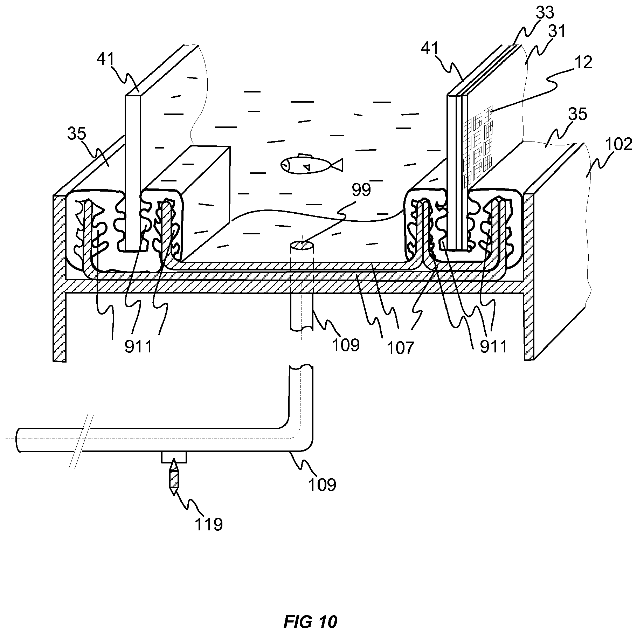

Figure 10 depicts an example of a system using supporting structure similar to described in association with figures 8 and 9. The jointing means 35 forms a surrounded structure comprising three holding grooves 911 arranged so that inner supporting profiles 107 are tightly fastened to two of the holding grooves 911 that can be entered from the same side of the jointing means 35 as shown in figure 10. The jointing means 35 is further supported by an outer support frame 102 that surrounds the jointing means 35. The third holding grooves 911, 913, that can be entered from the opposite side of the jointing means 35 than the above-mentioned two holding grooves 911, is configured to receive edge parts of glass plates 41. The glass plates 41 are, preferably, part of the bigger glass construction that can be used, for example, as an aquarium. At least on one side of the construction is also provided with the photovoltaic panel 31 comprising the plurality of the photovoltaic elements 12. Between the photovoltaic panel 31 and the glass plate 41 may a small space that is suitable for installing the cooling means 33, for example. A big space that is limited by the glass construction made of the glass plates 41 and a floor made of one of the inner supporting profiles 107 (maybe covered with suitable material) can contain water to serve as the aquarium. Connecting piping 109 underneath the aquarium and providing the piping 109 with a water flow connection 99 with the aquarium space, it also serves as water storage for a sprinkler system. When sprinkler nozzles 119 are located in the suitable distance (e.g. about ten meters) below the aquarium space (water storage) and the ampoule of the sprinkler nozzle is broken due to heat or other detected environmental property the sprinkler system functions by means of its intrinsic gravitational discharge.

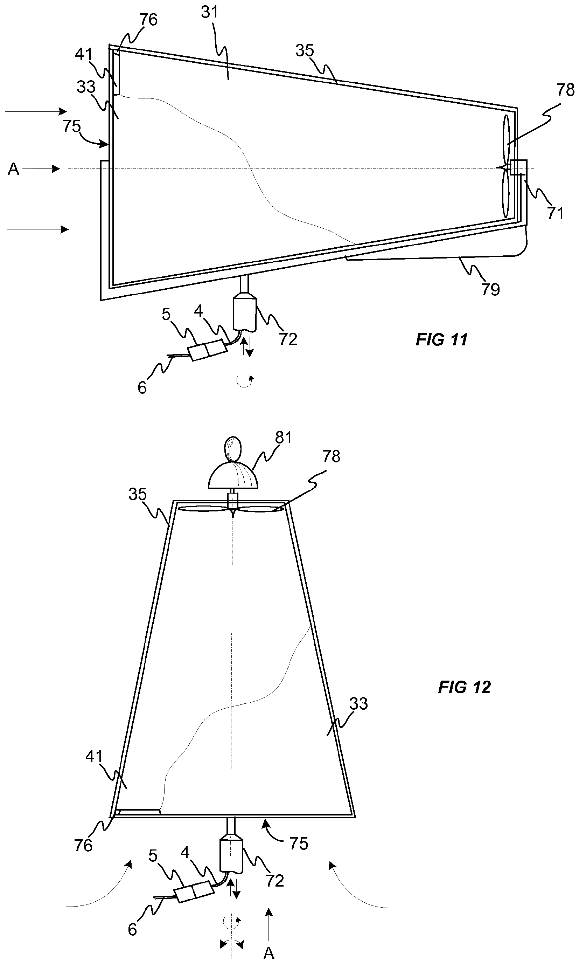

Figure 11 depicts an example of an energy panel arrangement according to an embodiment of the invention in which energy panels 3, 4 have other shapes than flat and rectangular shape. The energy panel arrangement comprises energy panels 3, 4 that may have arcuate shape so that when viewing the energy panel arrangement from the direction A the edge 75 of the arrangement may have circular, cylindrical, conical, elliptical, hexagonal or other arcuate shape. The energy panel arrangement may comprise any number of energy panels 3, 4 having any panel structure earlier described such as solar module 10, 20 with or without the additional panel 41. Arcuate shapes of the energy panel 3, 4 offer a great heat exchange surface in a smaller volume than flat and rectangular shapes. A further advantage is that the energy panel arrangement that comprises energy panels 3, 4 having arcuate shapes provides firstly a large surface that collects easily big amounts of dry air (e.g. wind from the arrow direction A) to cool down the cooling means 33 in the energy panel arrangement. Secondly, the air flow may propel a wind turbine 78 to produce wind energy. A sprayer 76 can be arranged around the edge 75 of the energy panel arrangement to humidify the air flow inside the arrangement to improve cooling and propelling characteristics. The jointing means 35 tightly fastens the energy panels 3, 4 to each other to form the energy panel arrangement. A profiled frame portion 71 is attached to the jointing means 35 as explained in association to figures 4-9 and movably connected a supporting pole 72, e.g. a supporting mast or rotating shaft, of the energy panel arrangement. Preferably, the profiled frame portion is connected at its one end to the wind turbine and a fin 79 is attached to it so that the edge 75 of the energy panel arrangement and wings of the wind turbine are oriented according to headwind optimally (so that wind blows towards the wings from direction A). Alternatively, instead of the wind turbine a ventilator 78 is used to suck air to increase the volume and output of the heat exchanger 33. The piping through the jointing means 35 is lead via the pole 72 as well as the electric wiring 4 from the energy panel arrangement to the connector 5 and output cabling 6. Also connections for other means to lead through 38, 39 other suitable objects, for example, a security valve, a manostat, a solenoid valve, a thermometer, a led lightning system, a drain hole, or other such possible components, are provided via the supporting pole 72, e.g. the supporting mast or rotating shaft.

Figure 12 depicts an example of the energy panel arrangement in which the wind turbine 81 rests on top of the upper end of the vertical supporting mast 72. The ventilator 78 can be installed inside the energy panel arrangement allowing a greater amount of air to be sucked in and ejected outside the energy panel arrangement. The vertical support mast 72 can be fixed to the ground. Other components are similar to those in the previous figure 11. Two or more heat exchanger modules 33 can be installed to each or part of the energy panel arrangement to improve energy production of the energy panel arrangement. Also additional panels 41 such as electroluminescent modules or tangential advertising lightning modules can be installed as earlier described. Alternatively, the energy panel arrangement shown in figure 12 is composed of two cylindrical metallic plates 31, 41 that are tightly fastened to each other by welded joint. In this case the jointing means 35 is the welded joint configured to form a frame structure around the energy panel.

Figure 13 depicts an example of an energy panel system according to an embodiment of the invention in which several energy panel arrangements are provided to produce energy. There is provided a tree structure of the energy panel arrangements that is supported by a supporting pole 72, e.g. a supporting mast or shaft which is preferably attached to the ground. The tree structure may be composed of one or more energy panel arrangements.Jn an example, the tree structure comprises on top a led lightning module 131 and below it a wind turbine 133, e.g. a direct-drive permanent magnet vertical axis wind turbine. Then follow different kinds of energy panel arrangements 137 comprising one or more energy panels 135. For example, the energy panel arrangement below the wind turbine 133 comprises several energy panels 135 where the jointing means 35 of each energy panel is tightly fastened to the profiled frame portion 52 (see figure 5) either individually or all together so that the energy panels 135 can be oriented according to the sun direction. The profiled frame portions 52 are attached to the supporting pole 72 and means to lead through the inlet pipe 8 and the outlet pipe 9 of the cooling means 33, electric wiring 4 and other connection from and to energy panels 135 are lead via the supporting pole 72 as shown in figure 12. The supporting pole 72 can be fixed mounted to the ground or it can be rotatable to orientate the tree structure of the energy panel arrangements according to the sun direction. The supporting pole 72 may further comprise at its ground end means to incline 1311 the tree structure according to the sun direction or air flow facing the energy panel arrangement. The means to incline 1311 is also configured to produce energy according to the inclination of the pole 72 that causes gas or fluid in a closed system to be compressed. Compressed nitrogen, hydrogen and oxygen may be produced in addition to electricity and heat in the energy panel system. In addition, the means to incline 1311 can be used as a pump to deliver water or other fluid further.

Figure 14 depicts some possible assembly examples of the energy panels in the energy panel arrangement seen above. Figure 14a) shows a single energy panel assembly that is supported by the profiled frame support 52 illustrated in figure 5. Figure 14b) shows a double energy panel assembly where both panels are supported by the profiled frame support 52. Figure 14c) shows a triple energy panel assembly where each panel is supported by the profiled frame support 52. Figure 14d) shows the energy panel assembly comprising four energy panels where each panel is supported by the profiled frame support 52. The tree structure of the energy panel arrangement that is supported by a supporting pole 72 as shown in figures 12 and 13 may also have other shapes. As earlier mentioned the tangential surface of the energy panel 3, 4 can have flat, planar or arcuate shape. The energy panel arrangement can simple be in a form of vertical cylinder composed of two cylindrical surfaces, or conical cylinder composed of two cylindrical surfaces, for example similar as shown in figure 12. The energy panel arrangement can also simply be composed of three or more vertical energy panels having rectangular shape that the jointing means 35, 45 is configured to be fastened each other. Thus, a cross sectional view of the energy panel arrangement from above can be a vertical or conical circle, triangle, tetragon, polygon, etc. The jointing means 35, 45 tightly fastening the energy panels to each other is also deformable to be part of the total shape of the energy panel arrangement of the tree structure.

Figure 15 depicts an example of an energy panel system according to an embodiment of the invention in which several tree structures of energy panel arrangements are connected to each other to produce energy. The supporting pole 72 of each of tree structures is connected with connecting means 155 to a steering rod 157 which is controlled by e.g. a motor to rotate the whole tree structure arrangement according to the sun direction. The several tree structures of energy panel arrangements are connected to form an energy forest comprising several energy trees. The solar, wind and thermal energy produced is collected from each tree structure of the energy panel arrangement and converted to be compliant with the public network.

Figure 16 depicts an example of an energy panel system according to an embodiment of the invention in which one or more energy panels 161 are used as window shutters in buildings. In figure 16 each window 163 has one shutter 161 but more than one shutter 161 may be used per each window 163, for example two half-shutters per window 163. At the day time when the shutters 161 are opened the energy panels 161 produce electric power. Both at the day time and the night time when the shutters 161 are either opened or closed the energy panels 161 comprising the heat exchanger 33 produce heat energy according to the outside temperature. The shutters 161 are preferable attached beside the windows 163 with the profiled frame support 52 shown in figure 5. One of the windows 163 shown in figure 5 is shut by the energy panel 161 and the decorative and darkening louvre panel 41 is visible. The piping to the heat exchanger 33 and electric wiring from the plurality of the photovoltaic elements 12 is lead to and from each energy panel 161 through jointing means 35 as earlier described. The piping and wiring is further connected via connecting means 167, 165 to transfer produced electric and heat energy further.

Figure 17 depicts an example of an energy panel system according to an embodiment of the invention in which energy panels 171 are tightly fastened to each other to form a network above the ground level 177. The networked assembly of energy panels 171 is installed on top of a deep trench in the ground that faces the wind, e.g. sea front, cliff, headlands or other windy location. The mouth 173 of the edge of the networked energy panels 171 and the trench has preferably arcuate shape, e.g. round, elliptical, etc. The exit orifice 174 can have any desired shape, such as round, elliptical, square, etc. A protecting net is used to prevent birds or other object to enter the cavity. The air entering the cavity will speed up as it goes deeper in the shrink (Venturi effect) towards the exit orifice 174. Energy panels 171 catch thermal energy brought in by the draft, and the plurality of the photovoltaic elements 12 produce electricity as air is thrown out through the exit tailpipe 175 and propel the wind turbine 176. The solar, wind and thermal energy produced is collected and converted to be compliant with the public network.

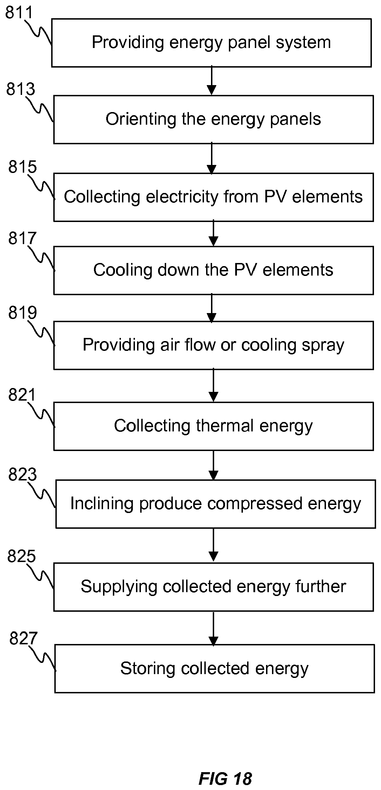

Figure 18 depicts a method for producing energy according to an embodiment of the invention. The method comprises a step 811 of providing an energy panel system comprising at least one energy panel according to the invention discussed earlier in this description, and a supporting structure configured to fasten the at least one energy panel to form an energy panel arrangement being oriented optimally to produce energy, wherein the supporting structure is configured to provide piping of the cooling means to the energy panels and electric conductors from the energy panels. Optionally, the method comprises an additional step 813 of supporting the energy panel arrangement to optimally orientate the energy panels according to the sun position. The method comprises a further step 815 of collecting electrical energy from the plurality of photovoltaic elements being exposed to solar radiation. The method comprises a further step 817 of feeding flowing material to the energy panel to cool down the plurality of photovoltaic elements. Optionally, the method comprises an additional step 819 of supporting the energy panel arrangement to receive at least one of the following: air flow and a spray of cooling agent to further cool down the plurality of photovoltaic elements. The method comprises a further step 821 of collecting thermal energy from the flowing material being exposed to thermodynamic heat transfer process during the cooling down. Optionally, the method comprises an additional step 823 of supporting the energy panel arrangement to incline according to air flow facing the energy panel and collecting compressed air or gas received from compression during inclining process. The method comprises a further step 825 of supplying the collected energy and a further step 827 of storing the collected energy that cannot be used on site immediately.

Various modifications and adaptations may become apparent to those skilled in the relevant arts in view of the foregoing description, when read in conjunction with the accompanying drawings and the appended claims. For example, the jointing means 35, 45 that forms a frame structure around the energy panel 3, 4, 20, 135, 161, 171 so that the photovoltaic panel 31 and the additional panel 41 are tightly fastened to each other but the means to lead through 25 an inlet pipe 8 and the means to lead through 26 an outlet pipe 9 are drilled through the additional panel 41 and sealed with fluid-tight seals to the additional panel 41. In this case the jointing means 35, 45 does not comprise the means to lead through 25 an inlet pipe 8 to the space for the cooling means 33 and the means to lead through 26 an outlet pipe 9 from the space of the cooling means 33.

## Claims

1. An energy panel (3, 4) comprising
at least one translucent plate (11, 31) supporting a plurality of photovoltaic elements (12),
cooling means (13, 33) arranged to cool down said plurality of photovoltaic elements, and
jointing means (35, 45),
wherein the jointing means is provided with a first holding groove (311) configured to fasten the translucent plate and the cooling means against each other so that said plurality of photovoltaic elements are effectively cooled down,
**characterized in that**
the jointing means are made of elastically deformable material and configured to form a hermetic frame structure around an outer edge part of the energy panel over the whole length of outer edge part.

2. The energy panel according to claim 1, wherein the jointing means (35, 45) is further provided with a second holding groove (413) configured to fasten the energy panel to a support structure.

3. The energy panel according to claim 1 or 2, wherein the cooling means is arranged between the translucent plate and an additional plate (15) so that the first holding groove is configured to fasten the translucent plate, the cooling means and the additional plate against each other.

4. The energy panel according to claim 3, wherein edges of the translucent plate and the additional plate are sealed together with sealing material (14) that is supported by a strut (17) so that the cooling means between the translucent and the additional plate is surrounded at its outer edges by the strut.

5. The energy panel according to any of claims 1-4, wherein the jointing means (35, 45) comprises at least one of the following means: means to lead through (25, 26, 36), an inlet pipe (8) to the cooling means and an outlet pipe (9) from the cooling means, and means to lead through (24, 34) an electric conductor from the plurality of the photovoltaic elements, and means to lead through (28, 29, 38, 39) a connection to additional component.

6. The energy panel according to any of claims 3-5, wherein the energy panel comprises two or more translucent plates so that between each pair of the translucent plates is placed the cooling means.

7. The energy panel according to any of claims 1-6, wherein the cooling means comprises a heat exchanger module.

8. The energy panel according to any of claims 1-7, wherein the first and second holding grooves (311, 313, 413) comprises lips (3110) protruding from inner walls (311a, 311b) of the holding grooves.

9. The energy panel according to any of claims 1-8, wherein a second holding groove (313) is configured to fasten the additional plate (41) to be suitable for decorative, informatics, promotional or other similar use.

10. The energy panel according to any of claims 1-9, wherein a shape of a tangential surface of the energy panel is flat, planar or arcuate.

11. An energy panel system comprising
at least one energy panel (3, 4, 10, 20, 135, 161, 171) according to any of claims 1-10, and
a supporting structure (52, 62, 71, 72, 77, 87, 102) configured to fasten the at least one energy panel to form an energy panel arrangement being oriented optimally to produce energy, wherein the supporting structure is configured to provide piping (8, 9) of the cooling means (33) to the energy panels and electric conductors (4) from the energy panels.

12. The energy panel system according to claim 11, wherein the supporting structure is fastened to the second holding groove (313, 413) of the jointing means of the energy panel.

13. The energy panel system according to claim 11 or 12, wherein the supporting structure comprises profiled holding means (52, 62) to fasten the jointing means (35, 45) of the energy panel.

14. The energy panel system according to any of claims 11-13, wherein the system further comprises a pole (72) configured to support at least one energy panel arrangement, wherein the supporting structure of the energy panel arrangement is at its one end fixed or movably connected to the pole.

15. The energy panel system according to claim 14, wherein the system further comprises a wind turbine (81) or a ventilator (78) or both being supported by the pole and comprising means to orientate (71, 72, 79)) the ventilator according to air flow in a propagation direction through the energy panel arrangement comprising energy panels having arcuate tangential surface shapes so that when viewing the energy panel arrangement from the propagation direction the edge of the panel arrangement has arcuate shape.

16. The energy panel system according to claim 15, wherein the system further comprises spraying means (76) connected to the supporting structure of the energy panel arrangement at opposite end of the energy panel arrangement than the wind turbine (81) or the ventilator (78).

17. The energy panel system according to any of claims 14-16, wherein the pole is configured to incline in the effect of air flow being directed towards the energy panel or rotate according to the sun position.

18. A method for producing energy, comprising
providing (811) an energy panel system according to any of claims 11-17 comprising at least one energy panel according to any of claims 1-10,
collecting (815) electrical energy from the plurality of photovoltaic elements being exposed to solar radiation,
feeding (817) flowing material to the energy panel to cool down the plurality of photovoltaic elements,
collecting (821) thermal energy from the flowing material being exposed to thermodynamic heat transfer process during the cooling down, and
supplying (825) the collected energy or storing (827) it.

19. The method according to claim 18, wherein the energy panel arrangement is supported (813) to optimally orientate the energy panels according to the sun position.

20. The method according to claim 18 or 19, wherein the energy panel arrangement is supported (819) to receive at least one of the following: air flow and a spray of cooling agent to further cool down the plurality of photovoltaic elements.

21. The method according to any of claims 18-20, wherein the energy panel arrangement is supported (823) to incline in the effect of air flow being directed towards the energy panel, wherein inclining the energy panel arrangement causes gas or fluid in a closed system to be compressed and collecting compressed fluid or gas received from compression during inclining process.

## Patentansprüche

1. Energiepaneel (3, 4), umfassend
mindestens eine lichtdurchlässige Platte (11, 31), die eine Mehrzahl von Photovoltaikelementen (12) trägt,
Kühlmittel (13, 33), die angeordnet sind, die Mehrzahl von Photovoltaikelementen zu kühlen, und
Verbindungsmittel (35, 45),
wobei das Verbindungsmittel mit einer ersten Haltenut (311) versehen ist, die ausgelegt ist, die lichtdurchlässige Platte und die Kühlmittel gegeneinander zu befestigen, so dass die Mehrzahl von Photovoltaikelementen effektiv heruntergekühlt wird,
**dadurch gekennzeichnet, dass**
die Verbindungsmittel aus einem elastisch verformbaren Material hergestellt sind und ausgelegt sind, eine hermetische Rahmenstruktur um einen Außenrandteil des Energiepaneels über die gesamte Länge des Außenrandteils zu bilden.

2. Energiepaneel nach Anspruch 1, wobei das Verbindungsmittel (35, 45) ferner mit einer zweiten Haltenut (413) versehen ist, die ausgelegt ist, das Energiepaneel an einer Tragstruktur zu befestigen.

3. Energiepaneel nach Anspruch 1 oder 2, wobei das Kühlmittel zwischen der lichtdurchlässigen Platte und einer zusätzlichen Platte (15) angeordnet ist, so dass die erste Haltenut ausgelegt ist, die lichtdurchlässige Platte, das Kühlmittel und die zusätzliche Platte gegeneinander zu befestigen.

4. Energiepaneel nach Anspruch 3, wobei Ränder der lichtdurchlässigen Platte und der zusätzlichen Platte zusammen mit einem Dichtungsmaterial (14) abgedichtet sind, das von einer Strebe (17) gestützt wird, so dass das Kühlmittel zwischen der lichtdurchlässigen und der zusätzlichen Platte an dessen Außenrändern von der Strebe umgeben ist.

5. Energiepaneel nach einem der Ansprüche 1 bis 4, wobei das Verbindungsmittel (35, 45) mindestens eins von den folgenden Mitteln umfasst: Mittel zum Durchführen (25, 26, 36), ein Einlassrohr (8) zum Kühlmittel und ein Auslassrohr (9) vom Kühlmittel, und Mittel zum Durchführen (24, 34) eines elektrischen Leiters von der Mehrzahl von Photovoltaikelementen und Mittel zum Durchführen (28, 29, 38, 39) einer Verbindung zu einer zusätzlichen Komponente.

6. Energiepaneel nach einem der Ansprüche 3 bis 5, wobei das Energiepaneel zwei oder mehr lichtdurchlässige Platten umfasst, so dass zwischen jedem Paar der lichtdurchlässigen Platten das Kühlmittel angeordnet ist.

7. Energiepaneel nach einem der Ansprüche 1 bis 6, wobei das Kühlmittel ein Wärmetauschermodul umfasst.

8. Energiepaneel nach einem der Ansprüche 1 bis 7, wobei die erste und die zweite Haltenut (311, 313, 413) Lippen (3110) umfasst, die von Innenwänden (311a, 311b) der Haltenuten abstehen.

9. Energiepaneel nach einem der Ansprüche 1 bis 8, wobei eine zweite Haltenut (313) ausgelegt ist, die zusätzliche Platte (41) zu befestigen, um für dekorative, Informatik-, verkaufsfördernde oder eine andere ähnliche Verwendung geeignet zu sein.

10. Energiepaneel nach einem der Ansprüche 1 bis 9, wobei eine Form einer tangentialen Fläche des Energiepaneels flach, eben oder bogenförmig ist.

11. Energiepaneelsystem, umfassend
mindestens ein Energiepaneel (3, 4, 10, 20, 135, 161, 171) nach einem der Ansprüche 1 bis 10, und
eine Tragstruktur (52, 62, 71, 72, 77, 87, 102), die ausgelegt ist, das mindestens eine Energiepaneel zu befestigen, um eine Energiepaneelanordnung zu bilden, die optimal ausgerichtet ist, um Energie zu erzeugen, wobei die Tragstruktur ausgelegt ist, Rohrleitungen (8, 9) des Kühlmittels (33) den Energiepaneelen und elektrische Leiter (4) von den Energiepaneelen bereitzustellen.

12. Energiepaneelsystem nach Anspruch 11, wobei die Tragstruktur an der zweiten Haltenut (313, 413) des Verbindungsmittels des Energiepaneels befestigt ist.

13. Energiepaneelsystem nach Anspruch 11 oder 12, wobei die Tragstruktur profilierte Haltemittel (52, 62) umfasst, um die Verbindungsmittel (35, 45) des Energiepaneels zu befestigen.

14. Energiepaneelsystem nach einem der Ansprüche 11 bis 13, wobei das System ferner eine Stange (72) umfasst, die ausgelegt ist, mindestens eine Energiepaneelanordnung zu tragen, wobei die Tragstruktur der Energiepaneelanordnung an ihrem einen Ende fest oder bewegbar mit der Stange verbunden ist.

15. Energiepaneelsystem nach Anspruch 14, wobei das System ferner eine Windturbine (81) oder einen Ventilator (78) oder beides umfasst, die von der Stange getragen werden, und Mittel zur Ausrichtung (71, 72, 79) des Ventilators entsprechend eines Luftstroms in einer Ausbreitungsrichtung durch die Energiepaneelanordnung umfasst, umfassend Energiepaneele mit bogenförmigen tangentialen Oberflächenformen, so dass bei Betrachtung der Energiepaneelanordnung aus der Ausbreitungsrichtung der Rand der Paneelanordnung eine bogenförmige Form aufweist.

16. Energiepaneelsystem nach Anspruch 15, wobei das System ferner ein Sprühmittel (76) umfasst, das mit der Tragstruktur der Energiepaneelanordnung an einem gegenüberliegenden Ende der Energiepaneelanordnung als die Windturbine (81) oder der Ventilator (78) verbunden ist.

17. Energiepaneelsystem nach einem der Ansprüche 14 bis 16, wobei die Stange ausgelegt ist, sich unter der Wirkung eines Luftstroms zu neigen, der in Richtung des Energiepaneels geleitet wird, oder sich entsprechend der Sonnenposition zu drehen.

18. Verfahren zur Erzeugung von Energie, umfassend
Bereitstellen (811) eines Energiepaneelsystems nach einem der Ansprüche 11 bis 17, umfassend mindestens ein Energiepaneel nach einem der Ansprüche 1 bis 10,
Aufnehmen (815) elektrischer Energie aus der Mehrzahl von Photovoltaikelementen, die Sonnenstrahlung ausgesetzt sind,
Einspeisen (817) von fließendem Material in das Energiepaneel, um die Mehrzahl von Photovoltaikelementen herunterzukühlen,
Aufnehmen (821) von Wärmeenergie aus dem fließenden Material, das während des Herunterkühlens einem thermodynamischen Wärmeübertragungsprozess ausgesetzt ist, und
Zuführen (825) der aufgenommenen Energie oder Speichern (827) derselben.

19. Verfahren nach Anspruch 18, wobei die Energiepaneelanordnung getragen (813) wird, um die Energiepaneele entsprechend der Sonnenposition optimal auszurichten.

20. Verfahren nach Anspruch 18 oder 19, wobei die Energiepaneelanordnung getragen (819) wird, um mindestens eins von dem Folgenden zu erhalten: Luftstrom und einen Sprühnebel von Kühlmittel, um die Mehrzahl von Photovoltaikelementen weiter herunterzukühlen.

21. Verfahren nach einem der Ansprüche 18 bis 20, wobei die Energiepaneelanordnung getragen wird (823), um sich unter der Wirkung eines Luftstroms zu neigen, der in Richtung des Energiepaneels geleitet wird, wobei Neigen der Energiepaneelanordnung bewirkt, dass ein Gas oder Fluid in einem geschlossenen System komprimiert wird und komprimiertes Fluid oder Gas, das von der Komprimierung während des Neigungsprozesses erhalten wird, aufgenommen wird.

## Revendications

1. Panneau d'énergie (3, 4) comprenant
au moins un plateau translucide (11, 31) supportant une pluralité d'éléments photovoltaïques (12),
des moyens de refroidissement (13, 33) agencés pour refroidir ladite pluralité d'éléments photovoltaïques, et
des moyens d'assemblage (35, 45),
dans lequel les moyens d'assemblage sont dotés d'une première rainure de maintien (311) configurée pour fixer le plateau translucide et les moyens de refroidissement l'un contre l'autre de façon à ce que ladite pluralité d'éléments photovoltaïques soit refroidie efficacement,
**caractérisé en ce que**
les moyens d'assemblage sont faits de matériau déformable élastiquement et configuré pour former une structure à cadre hermétique autour d'une partie de bord extérieur du panneau d'énergie sur toute la longueur de la partie de bord extérieur.

2. Panneau d'énergie selon la revendication 1, dans lequel les moyen d'assemblage (35, 45) sont en outre dotés d'une seconde rainure de maintien (413) configurée pour fixer le panneau d'énergie à une structure de support.

3. Panneau d'énergie selon la revendication 1 ou 2, dans lequel les moyens de refroidissement sont agencés entre le plateau translucide et un plateau supplémentaire (15) de façon à ce que la première rainure de maintien soit configurée pour fixer le plateau translucide, les moyens de refroidissement et le plateau supplémentaire l'un contre l'autre.

4. Panneau d'énergie selon la revendication 3, dans lequel des bords du plateau translucide et du plateau supplémentaire sont scellés ensemble avec du matériau de scellement (14) qui est supporté par une entretoise (17) de façon à ce que les moyens de refroidissement entre les plateaux translucide et supplémentaire soient entourés sur leurs bords extérieurs par l'entretoise.

5. Panneau d'énergie selon l'une quelconque des revendications 1 - 4, dans lequel les moyens d'assemblage (35, 45) comprennent au moins un des moyens suivants : un moyen pour guider au travers (25, 26, 36), un tuyau d'entrée (8) vers les moyens de refroidissement et un tuyau de sortie (9) des moyens de refroidissement, et un moyen pour guider au travers (24, 34) un conducteur électrique à partir de la pluralité d'éléments photovoltaïques et un moyen pour guider au travers (28, 29, 38, 39) une connexion vers le composant supplémentaire.

6. Panneau d'énergie selon l'une quelconque des revendications 3 - 5, dans lequel le panneau d'énergie comprend deux ou plusieurs plateaux translucides de façon à ce qu'entre chaque paire de plateaux translucides soient placés les moyens de refroidissement.

7. Panneau d'énergie selon l'une quelconque des revendications 1 - 6, dans lequel les moyens de refroidissement comprennent un module d'échangeur de chaleur.

8. Panneau d'énergie selon l'une quelconque des revendications 1 - 7, dans lequel les secondes rainures de maintien (311, 313, 413) comprennent des lèvres (3110) faisant saillie de parois intérieures (311a, 311b) des rainures de maintien.

9. Panneau d'énergie selon l'une quelconque des revendications 1 - 8, dans lequel une seconde rainure de maintien (313) est configurée pour fixer le plateau supplémentaire (41) pour être approprié à une utilisation décorative, informatique, promotionnelle ou similaire.

10. Panneau d'énergie selon l'une quelconque des revendications 1 - 9, dans lequel une forme d'une surface tangentielle du panneau d'énergie est plate, planaire ou arquée.

11. Système de panneau d'énergie comprenant
au moins un panneau d'énergie (3, 4, 10, 20, 135, 161, 171) selon l'une quelconque des revendications 1 - 10, et
une structure de support (52, 62, 71, 72, 77, 87, 102) configurée pour fixer l'au moins un panneau d'énergie pour former un agencement de panneau d'énergie étant orienté de façon optimale pour produire de l'énergie, dans lequel la structure de support est configurée pour fournir des tuyaux (8, 9) du moyen de refroidissement (33) vers les panneaux d'énergie et les conducteurs électriques (4) venant des panneaux d'énergie.

12. Système de panneau d'énergie selon la revendication 11, dans lequel la structure de support est fixée à la seconde rainure de maintien (313, 413) du moyen d'assemblage du panneau d'énergie.

13. Système de panneau d'énergie selon la revendication 11 ou 12, dans lequel la structure de support comprend des moyens de maintien profilés (52, 62) pour fixer les moyens d'assemblage (35, 45) du panneau d'énergie.

14. Système de panneau d'énergie selon l'une quelconque des revendications 11 - 13, dans lequel le système comprend en outre un mât (72) configuré pour supporter au moins un agencement de panneau d'énergie, dans lequel la structure de support de l'agencement de panneau d'énergie à son extrémité est connectée de manière fixe ou mobile au mât.

15. Système de panneau d'énergie selon la revendication 14, dans lequel le système comprend en outre une éolienne (81) ou un ventilateur (78) ou les deux étant supportés par le mât et comprenant des moyens pour orienter (71, 72, 79) le ventilateur en fonction de l'écoulement d'air dans une direction de propagation à travers l'agencement de panneau d'énergie comprenant des panneaux d'énergie ayant des formes de surface tangentielle arquées de façon à ce que lorsque l'on regarde l'agencement de panneau d'énergie depuis la direction de propagation, le bord de l'agencement de panneau a une forme arquée.

16. Système de panneau d'énergie selon la revendication 15, dans lequel le système comprend en outre un moyen de pulvérisation (76) connecté à la structure de support de l'agencement de panneau d'énergie à l'extrémité opposée de l'agencement de panneau d'énergie que l'éolienne (81) ou le ventilateur (78).

17. Système de panneau d'énergie selon l'une quelconque des revendications 14 - 16, dans lequel le mât est configuré pour s'incliner sous l'effet de l'écoulement d'air étant dirigé en direction du panneau d'énergie ou tourner selon la position du soleil.

18. Procédé de production d'énergie, comprenant
de fournir (811) un système de panneau d'énergie selon l'une quelconque des revendications 11-17 comprenant au moins un panneau d'énergie selon l'une quelconque des revendications 1-10,
de collecter (815) de l'énergie électrique venant de la pluralité d'éléments photovoltaïques étant exposés au rayonnement solaire,
d'alimenter (817) du matériau en écoulement au panneau d'énergie pour refroidir la pluralité d'éléments photovoltaïques,
de collecter (821) de l'énergie thermique venant du matériau en écoulement étant exposé au processus de transfert de chaleur thermodynamique durant le refroidissement, et
de fournir (825) l'énergie collectée ou de la stocker (827) .

19. Procédé selon la revendication 18, dans lequel l'agencement de panneau d'énergie est supporté (813) pour orienter de manière optimale les panneaux d'énergie selon la position du soleil.

20. Procédé selon la revendication 18 ou 19, dans lequel l'agencement de panneau d'énergie est supporté (819) pour recevoir au moins un des suivants : écoulement d'air et une pulvérisation d'agent de refroidissement pour continuer de refroidir la pluralité d'éléments photovoltaïques.

21. Procédé selon l'une quelconque des revendications 18-20, dans lequel l'agencement de panneau d'énergie est supporté (823) pour s'incliner sous l'effet de l'écoulement d'air étant dirigé en direction du panneau d'énergie, dans lequel incliner l'agencement de panneau d'énergie fait que le gaz ou le fluide dans un circuit fermé est comprimé et la collecte du fluide ou du gaz comprimé reçu de la compression durant la procédure d'inclinaison.
